# EUROPEAN PATENT APPLICATION

(11) **EP 2 657 962 A1**
(43) Date of publication of application: **30.10.2013**
(21) Application number: 13275090.2
(22) Date of filing: 16.04.2013
(51) Int. Cl.: H01L 21/48, H01L 21/60, H01L 23/498, H01L 23/485, H01L 31/0224, H01L 33/40, H01L 33/62, H01B 1/22

(54) **Electronic device with a metallisation layer having a high- and a low-melting-point component diffusion-bonded together and a synthetic resin layer covering the metallisation layer**

(30) Priority: 24.04.2012 JP 2012098837
(71) Applicant: Napra Co., Ltd., Katsushika-Ku Tokyo 124-0013 (JP)
(72) Inventor: Sekine, Shigenobu, Tokyo 124-0013 (JP); Sekine, Yurina, Tokyo 124-0013 (JP)
(74) Representative: Potter Clarkson LLP

(57) **Abstract**

An electronic device includes a substrate (11, 14B) and an electronic component (141-146, 14A, 14C, 140). The substrate (11, 14B) has a metallization trace (12, 12n, 12p). The metallization trace (12, 12n, 12p) has a metallization layer (121, 121n, 121p) and a synthetic resin layer (122, 122n, 122p). The metallization layer (121, 121n, 121p) has a high-melting-point metallic component (124) and a low-melting-point metallic component (123). The high-melting-point metallic component (124) and the low-melting-point metallic component (123) are diffusion bonded together and adhered to a surface of the substrate (11, 14B). The synthetic resin layer (122, 122n, 122p) is formed simultaneously with the metallization layer (121, 121n, 121p) to cover a surface of the metallization layer (121, 121n, 121p) with a thickness in the range of 5 nm to 1000 nm, preferably 5 nm to 500 nm. The electronic component (141-146, 14A, 14C, 140) is electrically connected to the metallization layer (121, 121n, 121p). The high-melting-point metallic particles (124) and the low-melting-point metallic particles (123) may have a nanocomposite structure.

## Description

### BACKGROUND OF THE INVENTION

### 1. Field of the Invention

The present invention relates to electronic devices, i.e., electrical products based on the technology of electronics.

### 2. Description of the Related Art

In electronic devices, as well known in the art, a trace pattern having a predetermined pattern is formed on one side of a substrate, and electronic components such as active components and passive components are soldered onto the trace pattern. The trace pattern can be obtained by applying an etching resist to a Cu foil previously formed on the substrate and then patterning the Cu foil by a photolithography process. In the trace pattern, the Cu foil is exposed at parts where the electronic components should be soldered, while parts where soldering is not required are covered with a solder resist film that is formed on the substrate using a thermosetting epoxy resin or the like. Then, the electronic components are soldered to the exposed Cu foil.

As described above, the conventional electronic devices are produced through many processes including a process of preparing a copper-clad substrate, a process of applying an etching resist, a photolithography process, a process of applying a solder resist, and a process of mounting components. Thus, there is a limit to cost reduction and improvement in productivity.

Instead of the above method, it is also possible to directly apply a conductive paste onto the substrate by screen printing. The conductive paste can be produced by dispersing a metal/alloy powder (conductive component) in an organic vehicle. The organic vehicle comprises a resin such as a thermosetting resin or a thermoplastic resin and a solvent. If necessary, a third component may be added so as to improve dispersibility of the metal powder or ensure fire retardancy.

In the trace pattern thus obtained, the metal powder is dispersed in the resin. This deteriorates the conductivity as compared with the case where the trace is a sheer metal conductor.

In order to improve the conductivity, therefore, the packing density can be increased by using a metal powder having a small particle size. However, the smaller the particle size, the more easily the metal powder aggregates, which makes it difficult to achieve uniform dispersion in the conductive paste. This also increases the contact area between adjacent metal particles to thereby increase the contact resistance, so that the conductivity cannot be sufficiently improved in accordance with an increase in the packing density.

It is also known that traces having good conductivity can be obtained by using a silver powder or a Cu powder as the metal powder. However, when an electric field is applied to the conductive paste containing the silver powder in a hot and humid atmosphere, electrodeposition of silver on an electrical circuit or an electrode, so-called migration, occurs to establish a short circuit between electrodes or traces formed by the trace pattern. As a countermeasure against the migration, for example, there has been known a method of applying a moisture-proof coating onto the silver powder or a method of adding a corrosion inhibitor such as nitrogen oxide to the conductive paste, but they are not sufficiently effective (see Japanese Unexamined Patent Application Publication No. 2001-189107). In order to obtain a highly conductive conductor, moreover, it is necessary to increase the amount of the silver powder to be added, but the silver powder is so expensive that the electronic device also becomes expensive.

On the other hand, since Cu can easily be oxidized after heating and hardening the conductive paste containing the Cu powder, the Cu powder reacts with oxygen in the air or the binder to form an oxide film thereon, thereby remarkably reducing the conductivity. As its countermeasure, Japanese Unexamined Patent Application Publication No. 5-212579 discloses a Cu paste into which a variety of additives are added to prevent the oxidation of the Cu powder and stabilize the conductivity. However, it is inferior to the silver paste in conductivity and also has a defect in shelf life and stability.

A conductive paste having a silver-plated Cu powder has also been suggested in order to achieve an improvement in migration and realize an inexpensive conductive paste (see Japanese Unexamined Patent Application Publication Nos. 7-138549 & 10-134636). However, a uniform, thick silver coating may result in insufficient improvement in migration. If the coating is thin, on the other hand, the filling amount of the conductive powder has to be increased for ensuring good conductivity, which may cause a reduction in adhesive force (adhesive strength) due to a relative decrease of the binder component.

Moreover, electronic devices for outdoor use, e.g., solar cells, need long-term durability against severe environmental changes. Particularly when solar cells are installed in desert having long sunshine duration or the like, the temperature range at the installation site may exceed 100 °C. However, if conventional solar cells having electrodes based on the above technology are put in such a harsh natural environment, the electrodes may deteriorate in a few years by oxidation.

As a means for solving the above problems, Japanese Patent No. 4778120 discloses a technology in which a high-melting-point metallic component and a low-melting-point metallic component are diffusion bonded together to form a metallization layer covered with a synthetic resin layer.

With this technology, it becomes possible to provide an electronic device with a high-quality, highly-reliable metallization trace which is excellent in conductivity, electrochemical stability, oxidation resistance, density, compactness and mechanical and physical strength and also has a high adhesion strength and bond strength to a substrate.

In this metallization trace, however, the metallization layer is covered with an insulating layer. Therefore, although it has the foregoing excellent effects, the insulating layer may be left between the metallization layer and a terminal electrode of an electronic component or other external conductors depending on how they are connected to the metallization layer, which decreases the reliability of electrical connection.

### SUMMARY OF THE INVENTION

In order to solve the above problem, an electronic device according to the present invention comprises a substrate. The substrate has a metallization trace. The metallization trace has a metallization layer and a synthetic resin layer. The metallization layer has a high-melting-point metallic component and a low-melting-point metallic component, and the high-melting-point metallic component and the low-melting-point metallic component are diffusion bonded together. The synthetic resin layer covers a surface of the metallization layer with a thickness in the range of 5 nm to 1000 nm.

As described above, since the high-melting-point metallic component and the low-melting-point metallic component are diffusion bonded together, the electronic device can be provided with a metallization layer which is excellent in electrochemical stability and oxidation resistance and hardly causes migration or an oxide film.

In addition, since the diffusion bonding of the high-melting-point metallic component and the low-melting-point metallic component provides a continuous metallization layer substantially free from a pore or disconnection, the density and compactness of the metallization layer can be improved, so that the electronic device can be provided with a metallization layer having a high conductivity and a high mechanical and physical strength. Moreover, since it contains both the high-melting-point metallic component and the low-melting-point metallic component, the electronic device can be provided with a highly conductive metallization layer depending on the material selection.

Furthermore, since the synthetic resin layer covers the surface of the metallization layer, the metallization layer can be prevented from being externally damaged and can also be improved in oxidation resistance, durability and weather resistance. Still furthermore, since the synthetic resin layer has adhesion strength and bond strength to the substrate in addition to adhesion strength and bond strength of the metallization layer itself, the whole metallization trace can be improved in adhesion strength and bond strength.

As a total result of the above effects, the electronic device can be provided with a high-quality, highly-reliable metallization trace which is excellent in conductivity, electrochemical stability, oxidation resistance, density, compactness and mechanical and physical strength and also has a high adhesion strength and bond strength to a substrate.

Furthermore, the synthetic resin layer covers the surface of the metallization layer with a thickness in the range of 5 nm to 1000 nm. When subjected to a heat treatment so as to connect an external conductor or electronic component to the metallization trace, the synthetic resin layer having a thickness in the range of 5 nm to 1000 nm can be softened or fluidified to flow out from the connection or can be melted and burned out. Thus, the synthetic resin layer can be eliminated from between the metallization layer and the external conductor or electronic component, ensuring that the external conductor or electronic component is directly connected to the metallization layer. Even if the synthetic resin layer is left between the metallization layer and the external conductor or the terminal electrode of the electronic component, when the synthetic resin layer has a thickness in the range of 5 nm to 1000 nm, electrical continuity can be established between them by a tunneling effect or the like. Since the metallization layer is covered with the synthetic resin layer except for the connection, the oxidation preventing effect due to the synthetic resin layer will never be impaired. Accordingly, the present invention can provide a metallization trace which ensures electrical connection between the metallization layer and the external conductor or electronic component and is effective in preventing oxidation of the metallization layer.

If the synthetic resin layer is thinner than 5 nm, it becomes less effective in preventing oxidation; if the synthetic resin layer exceeds 1000 nm, it tends to act as an insulating layer. In order to be effective in preventing oxidation and ensure conductivity, the thickness of the synthetic resin layer is preferably in the range of 5 nm to 500 nm.

Ideally, the synthetic resin layer should extend over the entire surface of the metallization layer, i.e., continuously and completely cover the entire surface of the metallization layer, but the metallization layer may be exposed through an opening in the surface of the synthetic resin layer. However, the opening through which the metallization layer is exposed should be made as small as possible so as not to impair the oxidation preventing effect.

Preferably, the synthetic resin layer is formed simultaneously with the metallization layer. In this case, the metallization layer will never be exposed to the air, unlike the case where the metallization layer and the synthetic resin layer are formed at different times. Therefore, the electronic device can be provided with a high-quality, oxidation-free metallization layer.

The metallization trace may be formed on a metal or alloy film such as a Cu film (Cu foil). When forming the metallization trace of the high-melting-point metallic component and the low-melting-point metallic component on the Cu film, the electrical resistance can be reduced by increasing the sectional area of the whole metallization trace without varying the thickness of the Cu foil. Alternatively, the electrical resistance can be reduced by increasing the sectional area of the whole metallization trace while reducing the thickness of the Cu foil.

The electronic device according to the present invention may be any electrical product based on the technology of electronics. Among them, particularly, the present invention discloses a computer, a mobile phone, a multilayer electronic equipment, an electronic device, an electronic component, a solar cell, a light-emitting diode, a light-emitting device, a lighting apparatus, a signal light and a liquid crystal display. Although they are referred to by specific names, they are electrical products based on the technology of electronics and therefore included in the category of the electronic device according to the present invention.

### Effects of the Invention

According to the present invention, as has been described above, the following effects can be obtained.
(1) It is possible to provide an electronic device with a high-quality, highly-reliable metallization trace which is excellent in oxidation resistance, conductivity, electrochemical stability, density, compactness and mechanical and physical strength and also has a high adhesion strength and bond strength to a substrate.
(2) It is possible to provide an electronic device in which when connecting an external conductor or electronic component to a metallization trace, electrical continuity can be certainly established between them while ensuring oxidation resistance.

The other objects, constructions and advantages of the present invention will be further detailed below with reference to the attached drawings. However, the attached drawings show only illustrative examples.

### BRIEF DESCRIPTION OF THE DRAWINGS

Fig. 1 is a drawing showing one embodiment of an electronic device according to the present invention;
Fig. 2 is a sectional view showing a part of a metallization trace in the electronic device shown in Fig. 1;
Fig. 3 is a sectional view taken at a different position of the metallization trace in the electronic device shown in Fig. 1;
Fig. 4 is a drawing showing a conductive paste for forming a metallization trace;
Fig. 5 is a drawing showing a coated state of the conductive paste shown in Fig. 4;
Fig. 6 is a sectional view showing another metallization trace in an electronic device according to the present invention;
Fig. 7 is a drawing showing a multilayer electronic device being another embodiment of an electronic device according to the present invention;
Fig. 8 is a plan view of a solar cell being still another embodiment of an electronic device according to the present invention;
Fig. 9 is a bottom view of the solar cell shown in Fig. 8 (which is opposite from a light incident side);
Fig. 10 is a sectional view of a light-emitting diode being still another embodiment of an electronic device according to the present invention;
Fig. 11 is a drawing showing a light-emitting device, a lighting apparatus or a signal light using the light-emitting diode shown in Fig. 10; and
Fig. 12 is a partial sectional view of a liquid crystal display using the light-emitting diode shown in Fig. 11 as a backlight.

### DESCRIPTION OF THE PREFERRED EMBODIMENTS

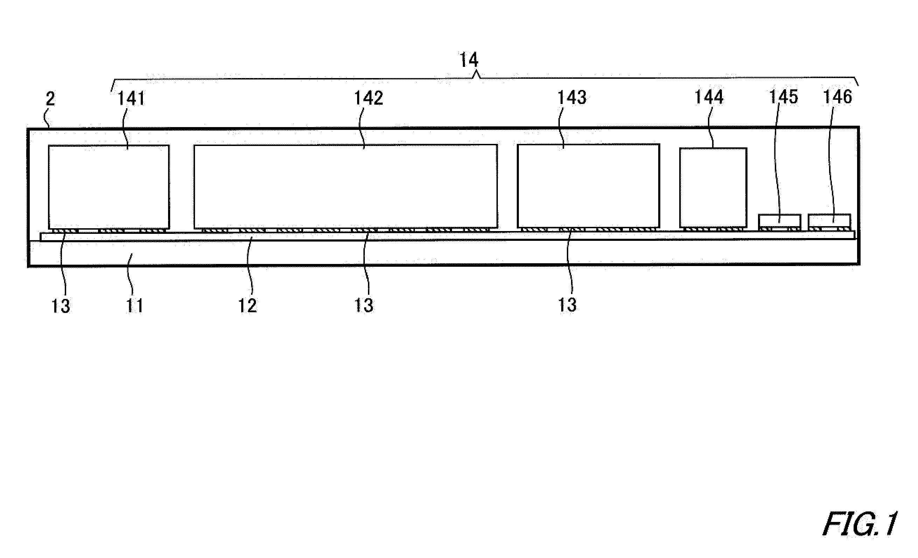

Referring to Fig. 1, an electronic device according to the present invention comprises a substrate 11 and electronic components 141 to 146. In general, they are arranged inside an outer jacket 2. The substrate 11 has a metallization trace 12 having a predetermined pattern. The substrate 11 may be an organic substrate or an inorganic substrate. It may also be a substrate capable of forming a semiconductor circuit, e.g., a Si substrate, or a simple insulating substrate.

The electronic components 141 to 146 are electrically connected to the metallization trace 12 over the substrate 11. In Fig. 1, the electronic components 141 to 146 are represented as a group by 14. The electronic components 141 to 146 are active components, passive components or composite components thereof, and their number, type, shape and so on can vary depending on the function and design of the electronic device. The electronic components 141 to 146 are designed to affect the behavior of electrons within the electronic system and associated force fields in a predetermined manner so that the system can fulfill an intended function. The electronic components 141 to 146 are connected to each other through the metallization trace 12, forming an electronic circuit having a specific function. The electronic components 141 to 146 may be packaged individually or packaged collectively into a module in the form of an integrated circuit.

The electronic device according to the present invention may also be embodied as an electronic device in which the substrate 11 serves the function of the electronic components 141 to 146 without clear distinction between the substrate 11 and the electronic components 141 to 146, for example, as a solar cell.

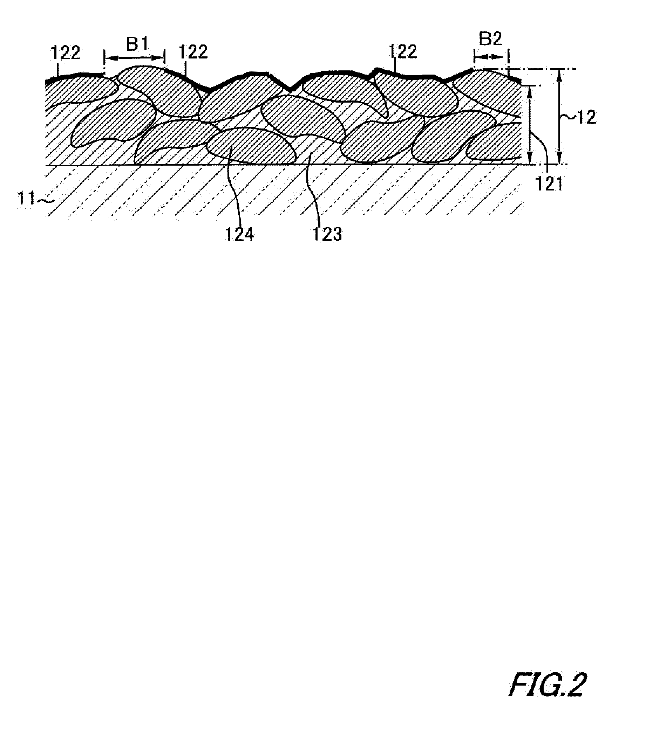

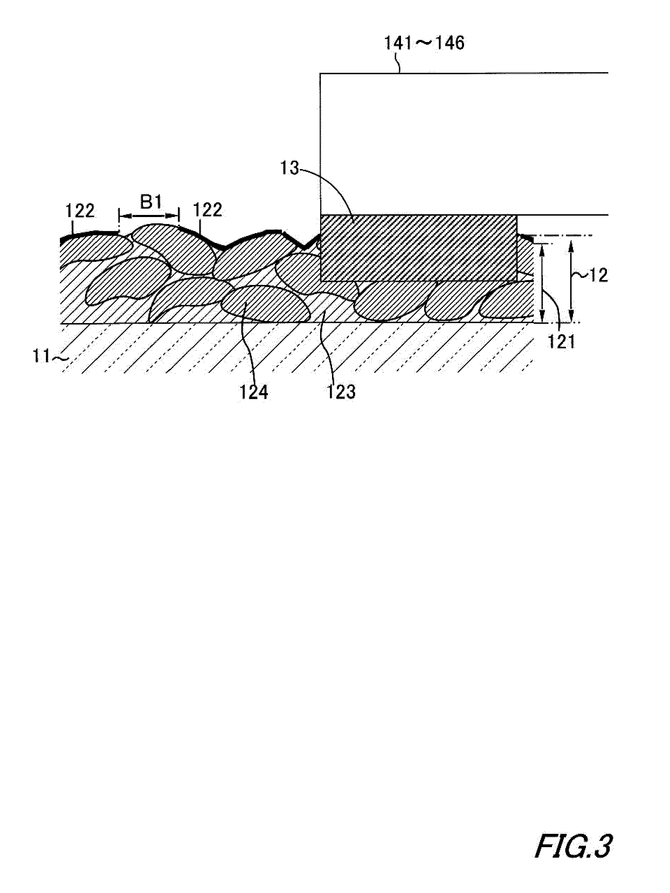

As shown in Figs. 2 and 3, the metallization trace 12 has a metallization layer 121 and a synthetic resin layer 122. The metallization layer 121 has a low-melting-point metallic component 123 and a high-melting-point metallic component 124, wherein the high-melting-point metallic component 124 and the low-melting-point metallic component 123 are diffusion bonded together to form a continuous metallic layer having a high packing density. The high-melting-point metallic component 124 may include at least one component selected from the group consisting of Ag, Cu, Au, Pt, Ti, Zn, Al, Fe, Si and Ni, while the low-melting-point metallic component 123 may include at least one component selected from the group consisting of Sn, In, Bi and Ga.

The synthetic resin layer 122 covers the surface of the metallization layer 121 with a thickness in the range of 5 nm to 1000 nm. If the synthetic resin layer 122 is thinner than 5 nm, it becomes less effective in preventing oxidation; if the synthetic resin layer 122 exceeds 1000 nm, it tends to act as an insulating layer. In order to be effective in preventing oxidation and ensure conductivity, the thickness of the synthetic resin layer 122 is preferably in the range of 5 nm to 500 nm.

The synthetic resin layer 122 may continuously cover not only the top face of the metallization layer 123 but also side faces in a line width direction and end faces in a length direction. As shown in Fig. 3, the electronic components 141 to 146 are connected such that a terminal electrode 13 penetrates through the synthetic resin layer 122 into the underlying metallization layer 121.

The synthetic resin layer 122 may comprise a thermosetting resin or a thermoplastic resin. When using the thermosetting resin, preferably, its curing temperature is higher than the melting point of the low-melting-point metallic component 123 and lower than the melting point of the high-melting-point metallic component 124.

Preferably, the resin includes at least one component selected from the group consisting of an epoxy resin, an acrylate resin and a phenolic resin. As a solvent for making a paste, it is possible to use well-known organic solvents such as butyl carbitol, butyl carbitol acetate, butyl cellosolve, methyl isobutyl ketone, toluene and xylene.

Ideally, the synthetic resin layer 122 should extend over the entire surface of the metallization layer 121, i.e., continuously and completely cover the entire surface of the metallization layer 121, but the metallization layer 121 may be exposed through openings B1, B2. Since the metallization layer 121 comprises the high-melting-point metallic component 124 and the low-melting-point metallic component 123, when low-melting-point metallic particles 123 are melted and diffusion bonded to high-melting-point metallic particles 124, for example, the high-melting-point metallic particles 124 may remain in the form of particles without being melted. In this case, the metallization layer 121 may have a complicated uneven surface in which protrusions where the high-melting-point metallic particles 124 jut out are mixed with recesses where the low-melting-point metallic particles 123 are melted. This tends to prevent the synthetic resin layer 122 from completely covering the surface of the metallization layer 121, thereby forming the openings B1, B2 through which the metallization layer 121 is exposed, particularly, at the protrusions where the high-melting-point metallic particles 124 jut out. The openings B1, B2 should be made as small as possible so as not to impair the oxidation preventing effect. This can be achieved by adjusting the composition ratio of the synthetic resin, the low-melting-point metallic component 123 and the high-melting-point metallic component 124.

As described above, since the metallization layer 121 comprises the high-melting-point metallic component 124 and the low-melting-point metallic component 123 and the high-melting-point metallic component 124 and the low-melting-point metallic component 123 are diffusion bonded together, the following effects can be obtained.

At first, since the high-melting-point metallic component 124 and the low-melting-point metallic component 123 are diffusion bonded together, the electronic device can be provided with a metallization layer 121 which is excellent in electrochemical stability and oxidation resistance.

When Ag is used as the high-melting-point metallic component, for example, the diffusion bonding occurs between Ag and the low-melting-point metallic component 123 in the metallization layer 121, increasing electrochemical stability to certainly prevent the migration of Ag. Also when Cu is used as the high-melting-point metallic component 124, the diffusion bonding occurs between Cu and the low-melting-point metallic component 123, preventing the oxidization of Cu.

In addition, since the diffusion bonding of the high-melting-point metallic component 124 and the low-melting-point metallic component 123 provides a continuous metallization layer 121 free from a pore or disconnection, the density and compactness of the metallization layer 121 can be improved to increase not only conductivity but also mechanical and physical strength. Moreover, since it contains both the high-melting-point metallic component 124 and the low-melting-point metallic component 123, the electronic device can be provided with a highly conductive metallization layer 121 depending on the material selection.

In the present invention, furthermore, since the synthetic resin layer 122 covers the surface of the metallization layer 121, the metallization layer 121 can be prevented from being externally damaged and can also be improved in oxidation resistance, durability and weather resistance. Still furthermore, since the synthetic resin layer 122 has adhesion strength and bond strength to the substrate in addition to adhesion strength and bond strength of the metallization layer 121 itself, the whole metallization trace 12 can be improved in adhesion strength and bond strength.

The synthetic resin layer 122 covers the surface of the metallization layer 121 with a thickness in the range of 5 nm to 1000 nm. When subjected to a heat treatment so as to connect the terminal electrodes 13 of the electronic components 141 to 146 to the metallization trace 12, the synthetic resin layer 122 having a thickness in the range of 5 nm to 1000 nm can be softened or fluidified to flow out from the connection or can be melted and burned out. Thus, the synthetic resin layer can be eliminated from between the metallization layer 121 and the terminal electrodes 13 of the electronic components 141 to 146, ensuring that the terminal electrodes 13 of the electronic components 141 to 146 are directly connected to the metallization layer 121. Even if the synthetic resin layer 122 is left between the metallization layer 121 and the terminal electrodes 13 of the electronic components 141 to 146, when the synthetic resin layer 122 has a thickness in the range of 5 nm to 1000 nm, electrical continuity can be established between them by a tunneling effect or the like. Since the metallization layer 121 is covered with the synthetic resin layer 122 except for the connection, the oxidation preventing effect due to the synthetic resin layer 122 will never be impaired. Accordingly, the present invention can provide a metallization trace 12 which ensures electrical connection between the metallization layer 121 and the terminal electrodes 13 of the electronic components 141 to 146 and is effective in preventing oxidation of the metallization layer 121.

With such a thickness, a part of the synthetic resin layer 122 can be chemically or mechanically removed to permit the external conductor or the terminal electrodes 13 of the electronic components 141 to 146 to be directly connected to the metallization layer 121.

Preferably, the synthetic resin layer 122 is formed simultaneously with the metallization layer 121. In this case, the metallization layer 121 will never be exposed to the air, unlike the case where the metallization layer 121 and the resin layer are formed at different times. Therefore, the electronic device can be provided with a high-quality, oxidation-free metallization layer 121.

The metallization layer 121 and the synthetic resin layer 122 can be formed at once by using a conductive past including a resin, a metallic component and a solvent.

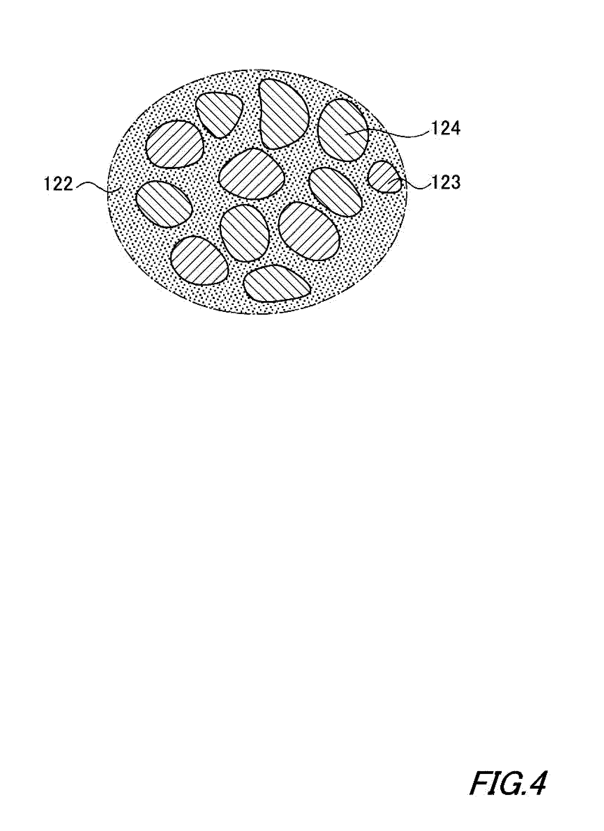

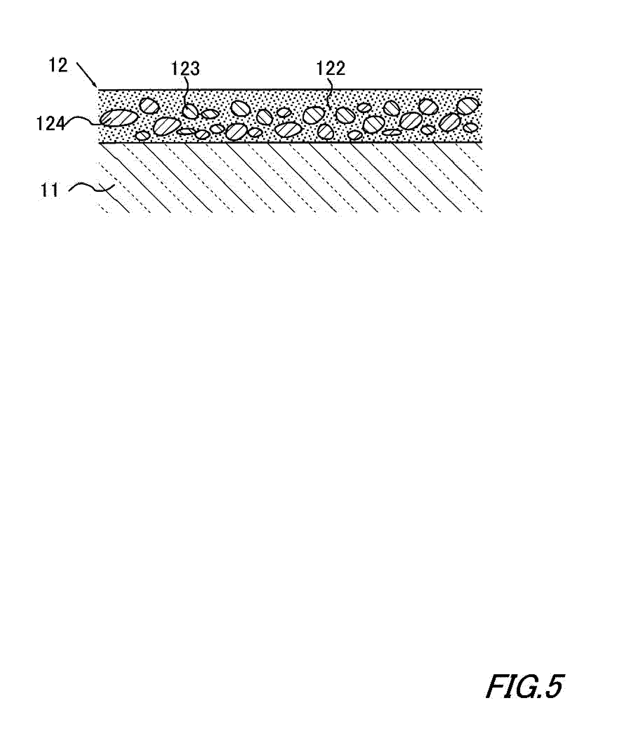

The metallization layer 121 and the synthetic resin layer 122 can be obtained such that a conductive past containing the metallic components (the high-melting-point metallic particles 124 and the low-melting-point metallic particles 123) and the resin 122 (see Fig. 4) is applied to the substrate 11 in a given pattern by screen printing, gravure printing or the like (see Fig. 5) and then subjected to a heat treatment to cause diffusion bonding. This eliminates the need for a process of preparing a copper-clad substrate, a process of applying an etching resist and a photolithography process which have been indispensable in the past, thereby achieving considerable cost reduction and improvement in productivity. The metallic particles may be round or flat. Preferably, they have a nanocomposite structure. The nanocomposite structure refers to a structure in which crystalline or non-crystalline nanoparticles are mixed or formed in a matrix.

There are two methods for causing diffusion bonding. One method utilizes a low melting point of a low-melting-point metallic material while the other utilizes nano-size effect, particularly, quantum size effect. In the former, the low-melting-point metallic component 123 is melted at its inherent low melting point and diffusion bonded to the high-melting-point metallic component 124. In the latter, high-melting-point metallic particles 124 whose particle size or thickness is as small as 100 nm or less are used as a high-melting-point metallic material and melted by the nano-size effect at a temperature lower than the inherent melting point (initial melting point) of the high-melting-point metallic material to cause diffusion bonding.

In the former method of utilizing the low melting point of the low-melting-point metallic material, preferably, heating is performed at a temperature higher than the melting point of the low-melting-point metallic component 123 and lower than the melting point of the high-melting-point metallic component 124, e.g., 100 to 300 °C. This heat treatment melts the low-melting-point metallic component 123, allowing the high-melting-point metallic component 124 and the low-melting-point metallic component 123 to aggregate into a packed structure where the space between adjacent particles of the high-melting-point metallic component 124 is filled with the molten low-melting-point metallic component 123, while the diffusion bonding (intermetallic bonding) occurs between the low-melting-point metallic component 123 and the high-melting-point metallic component 124. This diffusion bonding makes it possible to form a metallization layer 121 containing no resin. The metallization layer 121 sinks below the resin layer 122 because of the difference in specific gravity. This results in providing a metallization trace 12 in which the surface (top face and side faces) of the metallization layer 121 adhered to the substrate 11 is covered with the synthetic resin layer 122. Since the synthetic resin layer 122 covers the surface (top face and side faces) of the metallization layer 121, no additional process is required for applying the synthetic resin layer 122.

Even when Ag is used as the high-melting-point metallic component 124, the diffusion bonding also occurs between Ag and the low-melting-point metallic component 123 in the metallization layer 121, and in the entire conductive composition, furthermore, the metallization layer 121 is covered with the synthetic resin layer 122. This structure certainly prevents the migration of Ag. Also when Cu is used as the high-melting-point metallic component 124, the diffusion bonding occurs between Cu and the low-melting-point metallic component 123, and the metallization layer 121 is further covered with the synthetic resin layer 122, thereby preventing the oxidation of Cu.

The low-melting-point metallic particles 123 and high-melting-point metallic particles 124 may be round or flat. When the particles are flat, for example, it is desirable that they have a maximum thickness of 50 nm or less and a maximum diameter at least twice the thickness.

According to another embodiment, the conductive paste may include metallic particles prepared by covering high-melting-point metallic particles 124 with a low-melting-point metallic film 123 or, contrary to this, metallic particles prepared by covering low-melting-point metallic particles 123 with a high-melting-point metallic film.

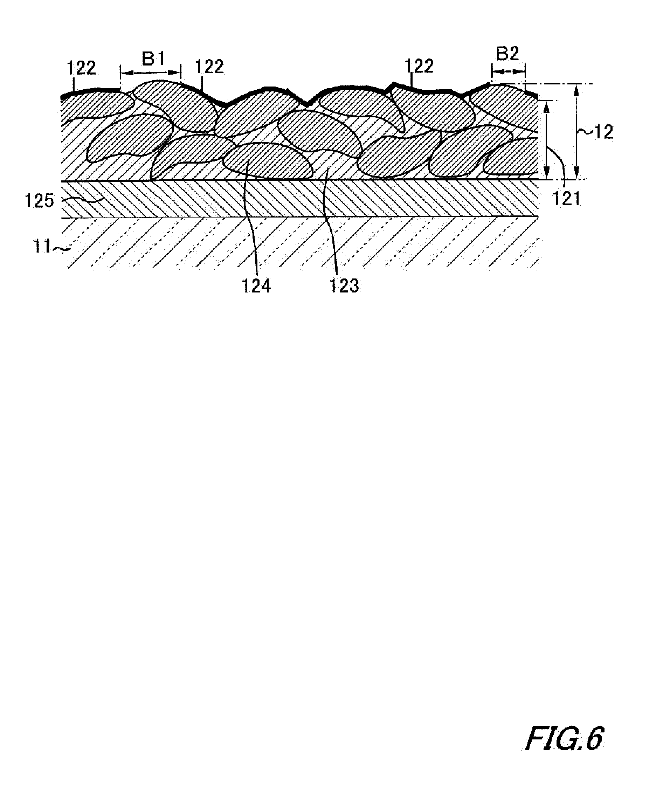

The metallization trace 12 of the high-melting-point metallic component 124 and the low-melting-point metallic component 123 may be formed on a metallic film 125 such as a Cu film, as shown in Fig. 6. When forming the metallization layer 121 of the high-melting-point metallic component 124 and the low-melting-point metallic component 123 on the Cu film (Cu foil) 125, the electrical resistance can be reduced by increasing the sectional area of the whole metallization trace 12 without varying the thickness of the Cu film 125. Alternatively, the electrical resistance can be reduced by increasing the sectional area of the whole metallization trace 12 such that while the thickness of the Cu film 125 is reduced, the metallization layer 121 of the high-melting-point metallic component 124 and the low-melting-point metallic component 123 to be adhered thereto is formed thick.

The electronic device according to the present invention may be any electrical product based on the technology of electronics. Typical examples include a computer, a mobile information equipment, a computer peripheral, an office automation equipment, a communication equipment, a business information terminal, an automatic recognition system, a car electronics equipment, an industrial machine, an entertainment equipment, an audio equipment, a video equipment and a home appliance. More specifically, they include, but not limited to, a liquid crystal display, a personal computer, an automotive navigation system, a mobile phone, a multilayer electronic equipment, a solar cell, a photovoltaic unit, a light-emitting diode, a light-emitting device, a lighting apparatus, a signal light, a video game console, a digital camera, a television set, a DVD player, an electronic organizer, an electronic dictionary, a hard disk recorder, a personal digital assistant (PDA), a video camera, a printer, a plasma display and a radio. Because of the limited space, a multilayer electronic equipment, a solar cell, a light-emitting diode, a light-emitting device, a lighting apparatus, a signal light and a liquid crystal display will be described below as an example of the above electronic device.

### 1. Multilayer Electronic Equipment

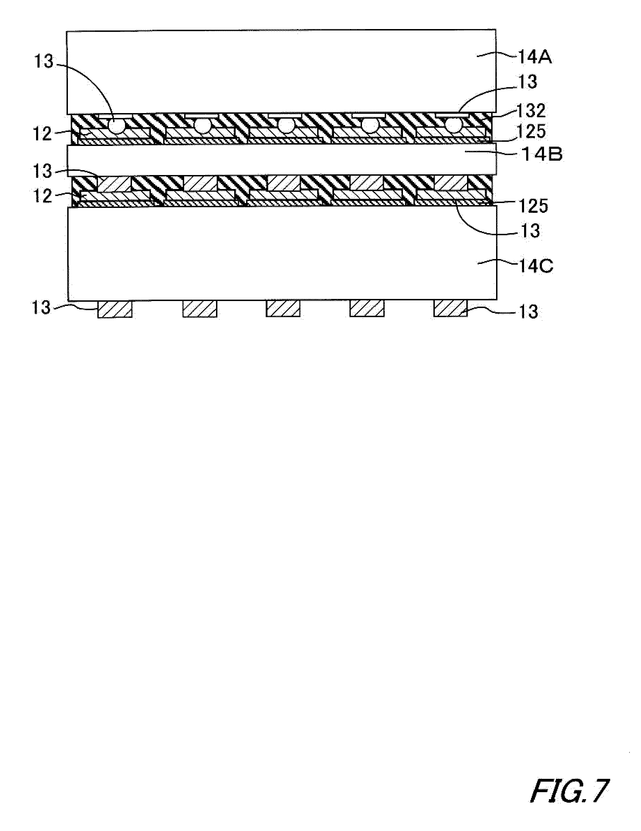

Referring first to Fig. 7, there is illustrated a multilayer electronic equipment in which a first chip part 14A, a second chip part 14B and a third chip part 14C are stacked. In a computer, for example, the first chip part 14A and the third chip part 14C may be a chip of a main memory and a logic IC chip to be connected thereto. The second chip part 14B may be an interposer to be disposed between the first chip part (main memory chip) 14A and the third chip part (logic IC chip) 14C and provide desired traces between them. Metallization traces 12 are formed in a predetermined pattern between the second chip part 14B and the third chip part 14C and between the second chip part 14B and the first chip part 14A. Terminal electrodes 13 of the first chip part 14A and terminal electrodes 13 of the second chip part 14B are connected to the metallization traces 12. Insulating layers 132 are provided between the first chip part 14A and the second chip part 14B and between the second chip part 14B and the third chip part 14C.

The metallization traces 12 comprise a metallization layer 121 and a synthetic resin layer 122 according to the present invention (see Figs. 2 and 3). The metallization layer 121 has a high-melting-point metallic component 124 and a low-melting-point metallic component 123, the high-melting-point metallic component 124 and the low-melting-point metallic component 123 being diffusion bonded together to form a continuous metallization layer 121. The synthetic resin layer 122 is formed simultaneously with the metallization layer 121 to cover the surface of the metallization layer 121 with a thickness in the range of 5 nm to 1000 nm.

Thus, the multilayer electronic equipment can be provided with high-quality, highly-reliable metallization traces 12 which are excellent in conductivity, electrochemical stability, oxidation resistance, density, compactness and mechanical and physical strength and also have a high adhesion strength between substrates.

Since the synthetic resin layer 122 covers the surface of the metallization layer 121 with a thickness in the range of 5 nm to 1000 nm, it can serve as a substantially conductive layer while serving as an oxidation preventing layer for the metallization layer 121. When subjected to a heat treatment so as to connect the first chip part 14A, the second chip part 14B and the third chip part 14C to the metallization traces 12, the synthetic resin layer 122 having a thickness in the range of 5 nm to 1000 nm can be softened or fluidified to flow out from the connection or can be melted and burned out. Thus, the synthetic resin layer can be eliminated from between the metallization layer 121 and the terminal electrodes of the first chip part 14A, the second chip part 14B and the third chip part 14C, ensuring that the terminal electrodes of the first chip part 14A, the second chip part 14B and the third chip part 14C are directly connected to the metallization layer 121. Even if the synthetic resin layer 122 is left between the metallization layer 121 and the terminal electrodes of the first chip part 14A, the second chip part 14B and the third chip part 14C, when the synthetic resin layer 122 has a thickness in the range of 5 nm to 1000 nm, electrical continuity can be established between them by a tunneling effect or the like. Since the metallization layer 121 is covered with the synthetic resin layer 122 except for the connection, the oxidation preventing effect due to the synthetic resin layer 122 will never be impaired. Accordingly, the present invention can provide a metallization trace 12 which ensures electrical connection between the metallization layer 121 and the terminal electrodes of the first chip part 14A, the second chip part 14B and the third chip part 14C and is effective in preventing oxidation of the metallization layer 121.

With such a thickness, a part of the synthetic resin layer 122 can be chemically or mechanically removed to permit the terminal electrodes of the first chip part 14A, the second chip part 14B and the third chip part 14C to be directly connected to the metallization layer 121.

When the second chip part 14B is an interposer, it is desirable that through-electrodes are formed in a thickness direction using a so-called TSV (through-silicon-via) technology. This realizes a three-dimensional circuit structure, contributing to increasing the capacity and the transfer rate and improving the high-frequency characteristics with a different approach from reducing the line width.

A vertical conductor that plays a central role in realizing the TSV structure is preferably a conductor formed by a fluid conductive material filling process. With the fluid conductive material filling process, for example, the vertical conductor (through-electrode) can be formed such that a fluid conductive material is filled into a fine hole previously formed in a substrate and the filled fluid conductive material is cooled and hardened while a pressure due to a pressing plate, an injection pressure or a rolling pressure is being applied thereto. With this fluid conductive material filling process, high-quality vertical conductors (through-electrodes) free from voids or the like can be formed in an extremely short period of time as compared with plating and the like. Therefore, a high-quality electronic device having a three-dimensional structure for increasing the capacity and the transfer rate and improving the high-frequency characteristics can be realized with a different approach from reducing the line width.

According to another embodiment, the three-dimensional structure can be realized by applying the TSV technology to the electronic components 141 to 146 themselves such as a memory or a logic IC.

### 2. Solar Cell

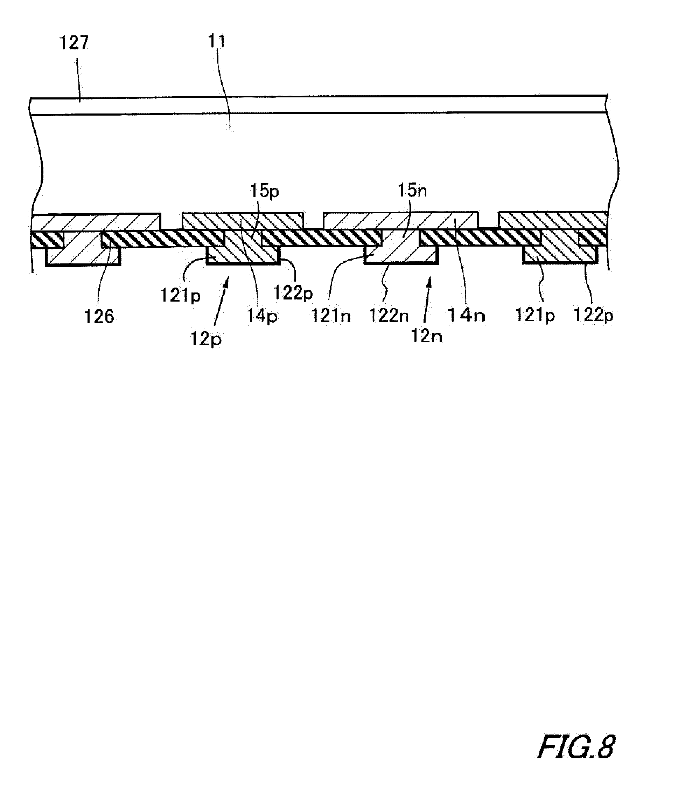

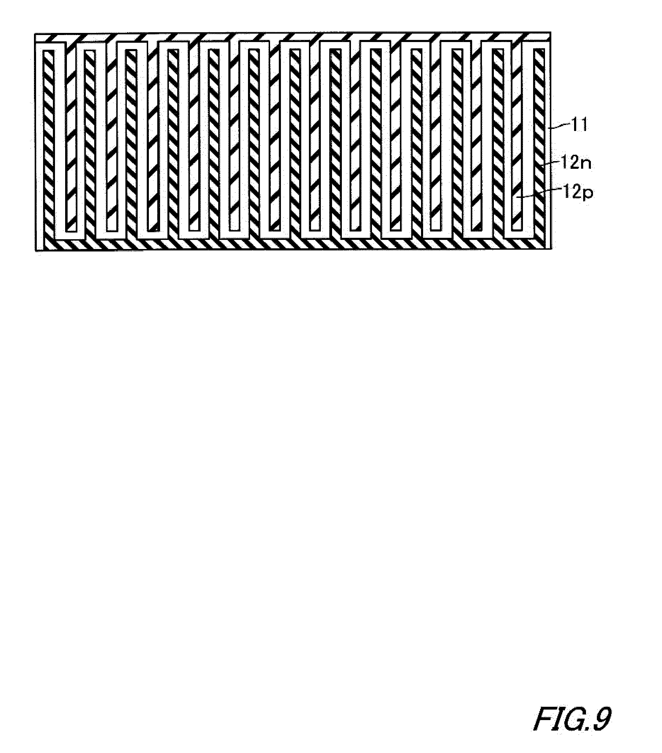

For electrical connection to a p+semiconductor layer 14p and an n+semiconductor layer 14n on a back side of a silicon substrate 11 (which is opposite from a light incident side), as shown in Figs. 8 and 9, after a passivation film 126 formed over the back side of the silicon substrate 11 is removed in a desired pattern, a p electrode contact 15p and an n electrode contact 15n are formed on the p+semiconductor layer 14p and the n+semiconductor layer 14n, respectively, at portions from which the passivation film 126 is removed. Moreover, a metallization trace 12n is formed on the passivation film 126 and the n electrode contact 15n, while a metallization trace 12p is formed on the passivation film 126 and the p electrode contact 15p. The metallization trace 12p and the metallization trace 12n are electrodes for mainly collecting a current generated in the solar cell and formed as an interdigital electrode. When a number of solar cells should be arranged on a single silicon substrate 11, either the metallization trace 12p or the metallization trace 12n can serve as a bus electrode for connecting the solar cells.

It should be noted that the metallization trace 12p comprises a metallization layer 121p and a synthetic resin layer 122p, as shown in Figs. 2 and 3. The metallization layer 121p has the high-melting-point metallic component 124 and the low-melting-point metallic component 123. The high-melting-point metallic component 124 and the low-melting-point metallic component 123 are diffusion bonded together. The synthetic resin layer 122p is formed simultaneously with the metallization layer 121p to cover the surface of the metallization layer 121p with a thickness in the range of 5 nm to 1000 nm.

Likewise, the metallization trace 12n comprises a metallization layer 121n and a synthetic resin layer 122n. The metallization layer 121n has the high-melting-point metallic component 124 and the low-melting-point metallic component 123. The high-melting-point metallic component 124 and the low-melting-point metallic component 123 are diffusion bonded together to form the metallization layer 121n. The synthetic resin layer 122n is formed simultaneously with the metallization layer 121n to cover the surface of the metallization layer 121n with a thickness in the range of 5 nm to 1000 nm. The formation process is the same as described above.

Since the synthetic resin layers 122p, 122n cover the surface of the metallization traces 12p, 12n with a thickness in the range of 5 nm to 1000 nm, they can serve as a substantially conductive layer while serving as an oxidation preventing layer for the metallization layers 121p, 121n. When subjected to a heat treatment so as to connect an external conductor (not shown) to the metallization traces 12p, 12n, the synthetic resin layers 122p, 122n having a thickness in the range of 5 nm to 1000 nm can be softened or fluidified to flow out from the connection or can be melted and burned out. Thus, the synthetic resin layer can be eliminated from between the metallization layers 121p, 121n and the external conductor, ensuring that the external conductor is directly connected to the metallization layers 121p, 121n. Even if the synthetic resin layers 122p, 122n are left between the metallization layers 121p, 121n and the external conductor, when the synthetic resin layers 122p, 122n have a thickness in the range of 5 nm to 1000 nm, electrical continuity can be established between them by a tunneling effect or the like. Since the metallization layers 121p, 121n are covered with the synthetic resin layers 122p, 122n except for the connection, the oxidation preventing effect due to the synthetic resin layers 122p, 122n will never be impaired. Accordingly, the present invention can provide metallization traces 12p, 12n which ensure electrical connection between the metallization layers 121p, 121n and the external conductor and is effective in preventing oxidation of the metallization layers 121p, 121n.

With such a thickness, a part of the synthetic resin layers 122p, 122n can be chemically or mechanically removed to permit the external conductor to be directly connected to the metallization layers 121p, 121n.

The metallization trace 12 according to the present invention can be applied not only to the illustrated solar cell but also to other types of solar cells. For example, it can be used for formation of a transparent electrode in a solar cell having a transparent electrode such as ITO on its light incident side or for formation of an electrode in a dye-sensitized solar cell.

### 3. Light-Emitting Diode

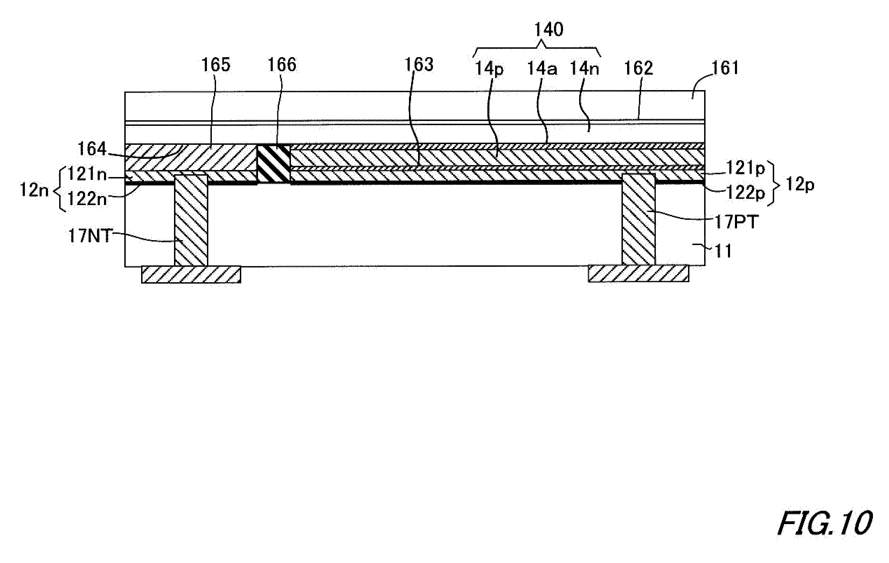

Fig. 10 shows a light-emitting diode according to the present invention. The light-emitting diode shown in Fig. 10 comprises a light-emitting element 140, an n metallization trace (first metallization trace) 12n, and a p metallization trace (second metallization trace) 12p. The light-emitting element 140 is deposited on a transparent crystal substrate 161. The transparent crystal substrate 161 is made of sapphire or the like and has a light-emitting surface on its top side, while the light-emitting element 140 is deposited on the other side of the transparent crystal substrate 161 opposite from the light-emitting surface.

The light-emitting element 140 is formed such that an n-type semiconductor layer 14n is formed on a buffer layer 162 deposited on the transparent crystal substrate 161 and a p-type semiconductor layer 14p is deposited over the n-type semiconductor layer 14n with an active layer 14a therebetween. The n-type semiconductor layer 14n close to the transparent crystal substrate 161 has an area 164 which does not overlap with the p-type semiconductor layer 14p, and a recess at this area 164 is filled with a metal conductive layer 165.

The metallization trace 12n is connected to the n-type semiconductor layer 14n, while the metallization trace 12p is connected to the p-type semiconductor layer 14p. The metallization trace 12n comprises a metallization layer 121n and a synthetic resin layer 122n, and the metallization layer 121n is joined to the surface of the metal conductive layer 165. The metallization trace 12p has a metallization layer 121p that is disposed on the same side as the metallization trace 12n and connected to the p-type semiconductor layer 14p through a reflection film 163.

First and second through electrodes 17NT, 17PT passing through a support substrate 11 and the synthetic resin layers 122n, 122p are connected to the metallization layers 121n, 121p, respectively.

The metallization trace 12n is formed at once using a common conductive paste including a resin and a metallic component. The metallic component has the high-melting-point metallic component 124 and the low-melting-point metallic component 123, the high-melting-point metallic component 124 and the low-melting-point metallic component 123 being diffusion bonded together into the metallization layer 121n. The synthetic resin layer 122n comprises the resin and covers the surface of the metallization layer 121n with a thickness in the range of 5 nm to 1000 nm..

The metallization trace 12p is also formed at once using a common conductive paste including a resin and a metallic component. The metallic component has the high-melting-point metallic component 124 and the low-melting-point metallic component 123, the high-melting-point metallic component 124 and the low-melting-point metallic component 123 being diffusion bonded together into the metallization layer 121p. The synthetic resin layer 122p covers the surface of the metallization layer 121p with a thickness in the range of 5 nm to 1000 nm. The reference sign 166 indicates an insulating layer.

With the above structure, the light-emitting diode can be provided with high-quality, highly-reliable metallization layers 121p, 121n which are excellent in conductivity, electrochemical stability, oxidation resistance, density, compactness and mechanical and physical strength and also have a high adhesion strength and bond strength to a substrate.

Since the synthetic resin layers 122n, 122p cover the surface of the metallization layers 121n, 121p with a thickness in the range of 5 nm to 1000 nm, they can serve as a substantially conductive layer while serving as an oxidation preventing layer for the metallization layers 121p, 121n. When subjected to a heat treatment so as to connect the first and second through electrodes 17NT, 17PT to the metallization traces 12p, 12n, the synthetic resin layers 122p, 122n having a thickness in the range of 5 nm to 1000 nm can be softened or fluidified to flow out from the connection or can be melted and burned out. Thus, the synthetic resin layer can be eliminated from between the metallization layers 121p, 121n and the first and second through electrodes 17NT, 17PT, ensuring that the first and second through electrodes 17NT, 17PT are directly connected to the metallization layers 121p, 121n. Even if the synthetic resin layers 122p, 122n are left between the metallization layers 121p, 121n and the first and second through electrodes 17NT, 17PT, when the synthetic resin layers 122p, 122n have a thickness in the range of 5 nm to 1000 nm, electrical continuity can be established between them by a tunneling effect or the like. Since the metallization layers 121p, 121n are covered with the synthetic resin layers 122p, 122n except for the connection, the oxidation preventing effect due to the synthetic resin layers 122p, 122n will never be impaired. Accordingly, the present invention can provide metallization traces 12p, 12n which ensure electrical connection between the metallization layers 121p, 121n and the first and second through electrodes 17NT, 17PT and is effective in preventing oxidation of the metallization layers 121p, 121n.

With such a thickness, a part of the synthetic resin layers 122p, 122n can be chemically or mechanically removed to permit the first and second through electrodes 17NT, 17PT to be directly connected to the metallization layers 121p, 121n.

The metallization trace 12 according to the present invention can be applied not only to the illustrated light-emitting diode but also to other types of light-emitting diodes. For example, it can be used for formation of a transparent electrode in a light-emitting diode having a transparent electrode such as ITO on its light-emitting side.

### 4. Light-Emitting Device, Lighting Apparatus or Signal Light

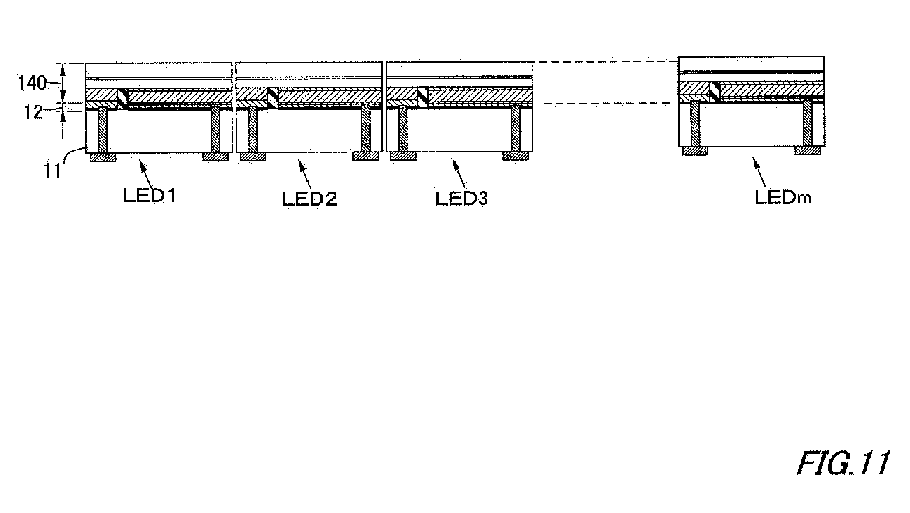

Fig. 11 shows a light-emitting device having a plurality (m) of light-emitting diodes LED1 to LEDm. The light-emitting diodes LED1 to LEDm are identical to that shown in Fig. 10 and comprise the light-emitting element 140, the n metallization trace (first metallization trace) 12n, and the p metallization trace (second metallization trace) 12p. The concrete structure of the light-emitting diodes LED1 to LEDm is the same as described with reference to Fig. 10. The light-emitting diodes LED1 to LEDm may be arranged in a single row or in a plurality of rows. Moreover, a common substrate may be used for the light-emitting diodes LED1 to LEDm. Furthermore, the arranged light-emitting diodes may include R, G and B ones or may be monochromatic.

The light-emitting device shown in Fig. 11 can also be used as a lighting apparatus or a traffic light. As understood from the foregoing description, the light-emitting device, the lighting apparatus and the signal light have high quality and reliability.

### 5. Liquid Crystal Display

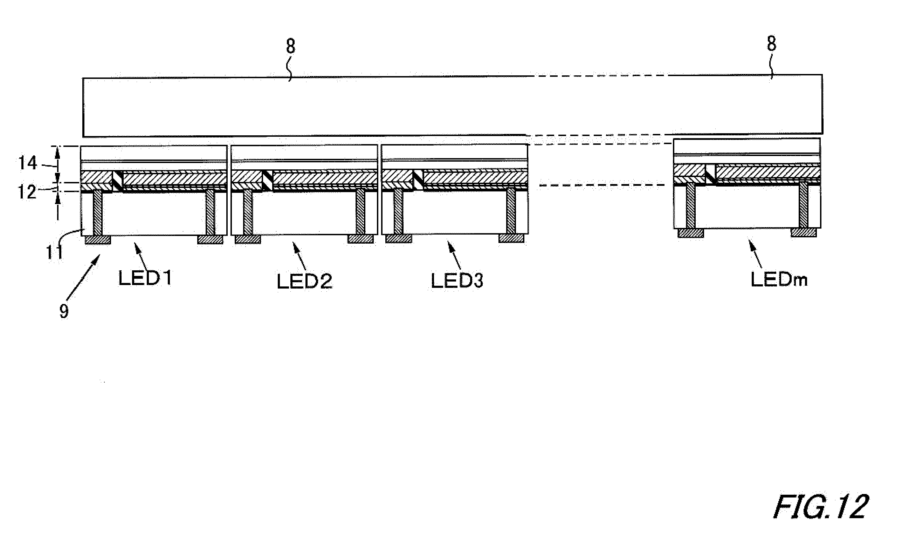

Fig. 12 is a drawing showing a liquid crystal display which is an assembly of a liquid crystal panel 8 and a backlight 9. The backlight 9 is formed such that a plurality (m) of the light-emitting diodes LED1 to LEDm shown in Fig. 11 are arranged in the form of matrix. As understood from the foregoing description, the liquid crystal display has high quality and reliability.

The present invention has been described in detail above with reference to preferred embodiments. However, obviously those skilled in the art could easily devise various modifications of the invention based on the technical concepts underlying the invention and teachings disclosed herein.

## Claims

1. An electronic device comprising a substrate (11) and an electronic component (141-146),
the substrate (11) having a metallization trace (12),
the metallization trace (12) having a metallization layer (121) and a synthetic resin layer (122),
the metallization layer (121) having a high-melting-point metallic component (124) and a low-melting-point metallic component (123), the high-melting-point metallic component (124) and the low-melting-point metallic component (123) being diffusion bonded together and adhered to a surface of the substrate (11),
the synthetic resin layer (122) being formed simultaneously with the metallization layer (121) to cover a surface of the metallization layer (121) with a thickness in the range of 5 nm to 1000 nm,
the electronic component (141-146) being electrically connected to the metallization layer (121).

2. The electronic device claimed in Claim 1, wherein the synthetic resin layer has a thickness in the range of 5 nm to 500 nm.

3. The electronic device claimed in Claim 1, wherein the high-melting-point metallic component and the low-melting-point metallic component have a nanocomposite structure.

4. The electronic device claimed in Claim 2, wherein the high-melting-point metallic component and the low-melting-point metallic component have a nanocomposite structure.

5. The electronic device claimed in Claim 1, which is a computer, a mobile information equipment, a computer peripheral, an office automation equipment, a communication equipment, a business information terminal, an automatic recognition system, a car electronic equipment, an industrial machine, an entertainment equipment, an audio equipment, a video equipment or a home appliance.

6. The electronic device claimed in Claim 2, which is a computer, a mobile information equipment, a computer peripheral, an office automation equipment, a communication equipment, a business information terminal, an automatic recognition system, a car electronic equipment, an industrial machine, an entertainment equipment, an audio equipment, a video equipment or a home appliance.

7. The electronic device claimed in Claim 3, which is a computer, a mobile information equipment, a computer peripheral, an office automation equipment, a communication equipment, a business information terminal, an automatic recognition system, a car electronic equipment, an industrial machine, an entertainment equipment, an audio equipment, a video equipment or a home appliance.

8. The electronic device claimed in Claim 4, which is a computer, a mobile information equipment, a computer peripheral, an office automation equipment, a communication equipment, a business information terminal, an automatic recognition system, a car electronic equipment, an industrial machine, an entertainment equipment, an audio equipment, a video equipment or a home appliance.
